# NEW EUROPEAN PATENT SPECIFICATION

(11) **EP 0 451 872 B2**
(45) Date of publication and mention of the opposition decision: **30.12.1998**
(45) Mention of the grant of the patent: 08.03.1995
(21) Application number: 91105894.9
(22) Date of filing: 11.04.1991
(51) Int. Cl.: H04N 5/44

(54) **Remote control system**
Fernsteuersystem
Système de télécommande

(30) Priority: 13.04.1990 JP 98882/90
(43) Date of publication of application: 16.10.1991
(73) Proprietor: SONY CORPORATION, Tokyo (JP)
(72) Inventor: Goto, Teiyu, Shinagawa-ku, Tokyo (JP); Okura, Yukiko, Shinagawa-ku, Tokyo (JP); Terashima, Toshiyuki, Shinagawa-ku, Tokyo (JP); Nonogaki, Masaru, Shinagawa-ku, Tokyo (JP)
(74) Representative: Schmidt-Evers, Jürgen, Dipl.-Ing.

(56) References cited:
- EP-A- 157 373
- EP-A- 347 686
- WO-A-89/04515
- AT-B- 376 538
- DE-A- 3 310 580
- US-A- 4 866 542
- FUNKSCHAU, vol. 25, 1980, Franzis Verlag, Munich, DE "Funkfernsteuern" pages73-74

## Description

### BACKGROUND OF THE INVENTION

### Field of the Invention

The present invention relates to a remote control system having a television receiver which can be controled by infrared remote control signals.

### Description of the Prior Art

Thus far, the following controlling input apparatus used for remote control systems, microcomputers, and so forth have been known.

Key input apparatus where data is input by key operations;
mouse input apparatus;
track ball input apparatus where a rotatable ball is manually rotated;
Jog shuttle input apparatus where a rotating plate is manually rotated; and
Joy stick input apparatus where a stick is moved forwardly, reversely, leftwardly, and rightwardly.

With respect to the key input apparatus, each key comes with one function. For example, to move the cursor upwardly and downwardly, two keys are required. Thus, the key input apparatus requires a large space for providing them. Moreover, another disadvantage of the key input apparatus is that the operator should usually watch his or her hand while operating the keys thereof.

With respect to the mouse input apparatus and the track ball input apparatus, since they are freely moved in the four directions, namely up, down, left, and right directions, it is difficult to move the cursor in a fixed direction. Moreover, the mouse input apparatuses require a moving space.

In addition, to validate data being input from the input apparatus, it is required to input commands of an enter and an execution. To input such commands, the mouse input apparatus, track ball input apparatus, and jog shuttle input apparatus should provide dedicated key switches.

With respect to the jog shuttle input apparatus, in the case of a remote control operation, the operator should use his or her both hands. Moreover, with respect to the joy stick input apparatus, output signals are generated with switches which are turned on and off in accordance with the stick positions. Thus, the jog shuttle input apparatus is not suitable for operations which analogically change a controlling amount.

As the input apparatuses which are used for controlling units with a display unit such as a CRT display, thus far, the key input apparatus have been mostly used. Thus, the operator should conduct a key input operation while watching the screen of the display unit and many keys. A remote control system using a roller according to the preamble of claims 1 and 2 is known from WO 89/04515.

### OBJECTS AND SUMMARY OF THE INVENTION

It is, therefore, an object of the present invention is to provide a remote control system which solves the aforementioned problems of the conventional controlling input apparatuses.

Another object of the present invention is to provide a remote control system which can readily operate even if the number of controlled subjects is increased. These objects are realized by the remote control system according to claim 1 or 2.

When a roller is rotated by a finger of the operator, detection pulses in accordance with the rotating direction and the amount of rotation of the roller are generated. The generated pulses are converted into signals representing the rotating direction and the amount of rotation of the roller by a first detection circuit Thus, the single roller works as both a pointing device and a controlling amount input device. When the roller is pressed, a switch is turned on and thereby a signal in accordance with the pressing operation is generated by a detection circuit. Consequently, an encoder signal can be generated without another switch.

The above, and other, objects, features and advantage of the present invention will become readily apparent from the following detailed description thereof which is to be read in connection with the accompanying drawings.

### BRIEF DESCRIPTION OF THE DRAWINGS

Fig. 1 is a block diagram showing a commander of an embodiment of the present invention;
Figs. 2A, 2B, and 2C are an external view showing the structure of the commander, a perspective view thereof, and an external view showing another example thereof;
Fig. 3 (Fig. 3A and 38) is a timing chart of detection pulse signals generated by a roller section;
Fig. 4 is a block diagram showing the circuit structure of a television receiver of the embodiment of the present invention;
Fig. 5 is an external view showing the television receiver; and
Figs. 6A, 6B, and 6C are schematic diagrams showing screens describing the operations of the embodiment of the present invention.

### DETAILED DESCRIPTION OF THE PREFERRED EMBODIMENTS

With reference to the accompanying drawings, an embodiment according to the present invention will be described. The present invention is applied to a system both for remotely controlling a television receiver and for controlling another unit through a microcomputer provided in the television receiver.

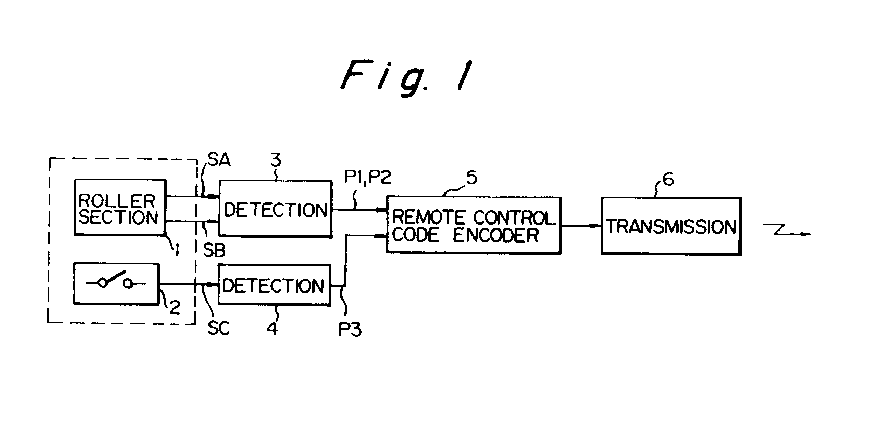

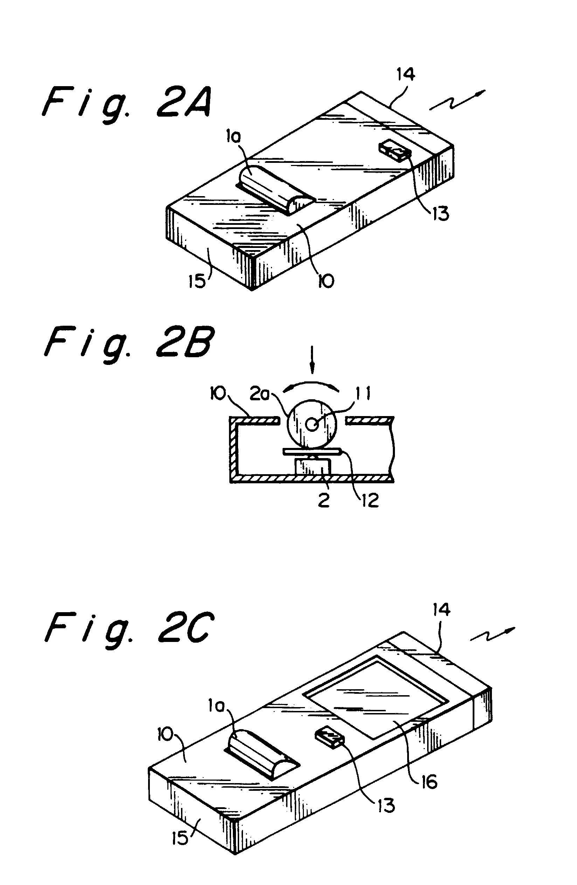

Fig. 1 is a block diagram showing the composition of a remote controlling commander. In the figure, reference numeral 1 is a roller section and reference numeral 2 is a switch provided along with the roller section 1, for example, a tact switch. As shown in Figs. 2A and 28, the roller section 1 is rotatably supported by a shaft 11 to a case 10. A roller 1a is disposed on the upper surface of the case 10, the peripheral surface of the roller 1a protruding from the case 10. The shaft 11 is a rod shaped spring. When the roller 1a is pressed downwardly, the switch 2 is turned on through an auxiliary plate 12. A rotation detector (not shown in the figure) for generating a detection pulse signal in accordance with the rotation of the roller 1a is provided at the roller section 1. More specifically, detection pulse signals SA and SB are generated by a magnetic detector which is composed of a rotary switch, a magnet, and a hole device or an optical detector which is composed of a light emitting device, a light receiving device, and a rotating slit plate.

In addition, on the case 10, a power switch 13 of the commander is disposed. From an end surface 14, a remote control signal which is a modulated infrared ray is transmitted. As shown in Fig. 2C, it is also possible to provide on the commander a display section 16 such as a liquid crystal display so as to operate the roller 1a while watching the display section 16.

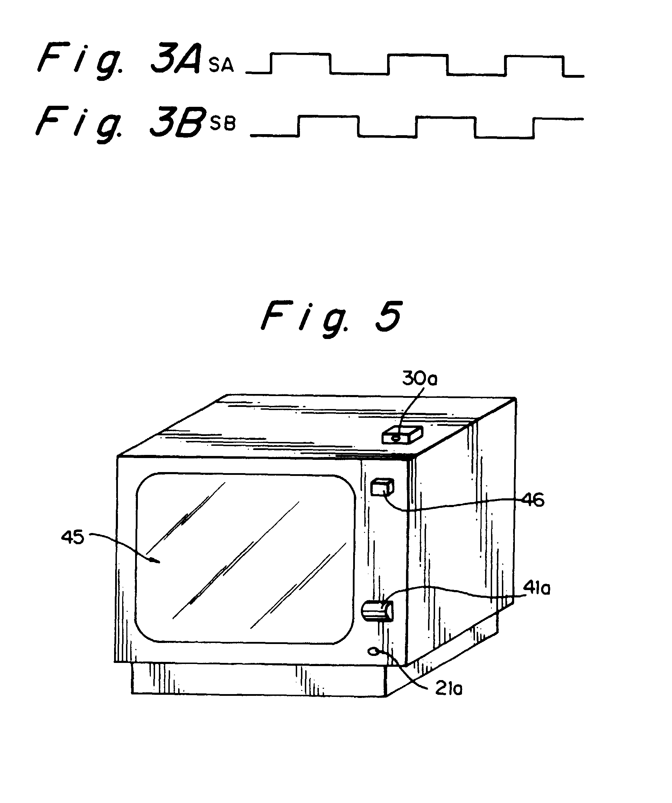

Fig. 3 is a timing chart showing two-phase detection pulse signals SA and SB which are generated in accordance with the rotations of the roller 1a. The relationship of the phases of the detection pulse signals SAand SB represents the rotating direction of the roller 1a. The number of pulses which are generated represents the amount of rotation of the roller 1a. The number of pulses of the detection pulse signals SA and SB which are generated for each rotation of the roller 1a are predetermined. The frequencies of the detection pulse signals SA and SA are proportional to the rotating speed of the roller 1a. As shown in Fig. 3, when the detection pulse signal SA rises before the detection pulse signal SB rises, the operator has moved his or her finger in the direction of the end surface 14 and thereby the roller 1a has been rotated. The rotation of the roller 1a in the direction of the end surface 14 causes the cursor on the screen of the television receiver to move upwardly. In contrast, when the operator moves his or her finger in the direction of the end surface 15 and thereby the roller 1a is rotated, the detection pulse SB rises before the detection pulse SA rises. The rotation of the roller 1a in the direction of the end surface 15 causes the cursor on the screen of the TV apparatus to move downwardly. The amount of rotation of the roller 1a can be detected by counting the number of pulses of the detection pulse signal of one type, for example, SA.

A detection circuit 3 detects the rotating direction and the amount of rotation of the roller 1a by using the detection pulse signals SA and SB. For example, the detection circuit 3 generates 2-bit code signals P1 and P2. A detection circuit 4 generates a 2-bit code signal P3 which represents that the roller 1a is pressed by using a pulse signal SC in accordance with the ON/OFF state of the switch 2. As an example, a code signal P1 representing the upward movement is set to (01); a code signal P2 representing the downward movement is set to (10); and a code signal P3 representing the depression of the roller 1a is set to (11). The amount of rotation is expressed by the number of pulses of the code signals P1 and P2. It is possible to set the number of bits to 4 bits or the like besides 2 bits.

The code signals P1, P2, and P3 from the detection circuits 3 and 4 are supplied to a remote control code encoder 5. The encoder 5 converts the code signals P1, P2, and P3 to a remote control signal in a predetermined format. The remote control signal is supplied to a transmission circuit 6. The transmission circuit 6 is provided with a light emitting diode and its drive amplifier. The remote control signal is converted into an infrared ray signal. The infrared ray signal is radiated from the transmission circuit 6 to the television receiver.

Fig. 4 is a block diagram of the television receiver. The infrared ray signal is converted into an electric signal, which is a remote control signal, by a reception circuit 21. The remote control signal is supplied to a remote control decoder 22. The decoder 22 decodes the remote control signal into the code signals according to the rotating direction, the amount of rotation, and the depression of the roller. The resultant signals from the decoder 22 are supplied to a CPU 23.

In accordance with a program stored in a ROM 24, the CPU 23 supplies control signals to a display control circuit 25, a superimpose unit 26, internally controlled subjects 29, a transmission circuit 30, and a bus output terminal 31. In this embodiment, the internally controlled subjects 29 are circuits with respect to the television receiver. RGB signals representing the cursor information from the display control circuit 25, the roller state information and so forth are mixed with input RGB signals from an input terminal 27 at the superimpose unit 26. The superimposed signals are output from an output terminal 28. The superimposed signals are supplied to a CRT connected to the output terminal 28. A transmission circuit 30 generates a remote control signal which is an infrared ray signal. The transmission circuit 30 is provided so as to remotely control another unit such as a VTR (video tape recorder).

The television receiver is also provided with a roller section 41 and a switch 42. A detection signal from the roller section 41 is supplied to a detection circuit 43. A detection signal from the switch 42 is supplied to a detection circuit 44. The output signals from the detection circuits 43 and 44 are supplied to the CPU 23. The composition of the input apparatus is the same as that of the aforementioned commander. Thus, the description of the input apparatus is omitted.

As shown in Fig. 5, a roller 41a is disposed on the front panel of the television receiver. Reference numeral 21a is a light receiving section of the reception circuit 21. Reference numeral 30a is a light emitting section of the transmission circuit 30. Reference numeral 45 is a display for displaying images. Reference numeral 46 is a power switch. The radiation of the light emitting section 30a can be adjusted in any direction.

In the aforementioned embodiment, while the powerofthe television receiver is turned on, when the roller 1a is pressed, a menu screen is displayed on the display 45. As an alternative method, it is possible to press the roller 1a twice in a very short interval, namely to perform a double click operation of the roller 1a so as to evoke the menu screen. The menu screen is used to designate the switching of the video input of the television receiver, select the television receiver or an external unit to be controlled, and select one of controlled subjects of the television receiver. The controlled subjects of the television receiver are daily controlled subjects such as channel selection and sound volume control and adjustment subjects such as screen brightness. It is possible to display the daily controlled subjects followed by the adjustment subjects by pressing the roller 1a.

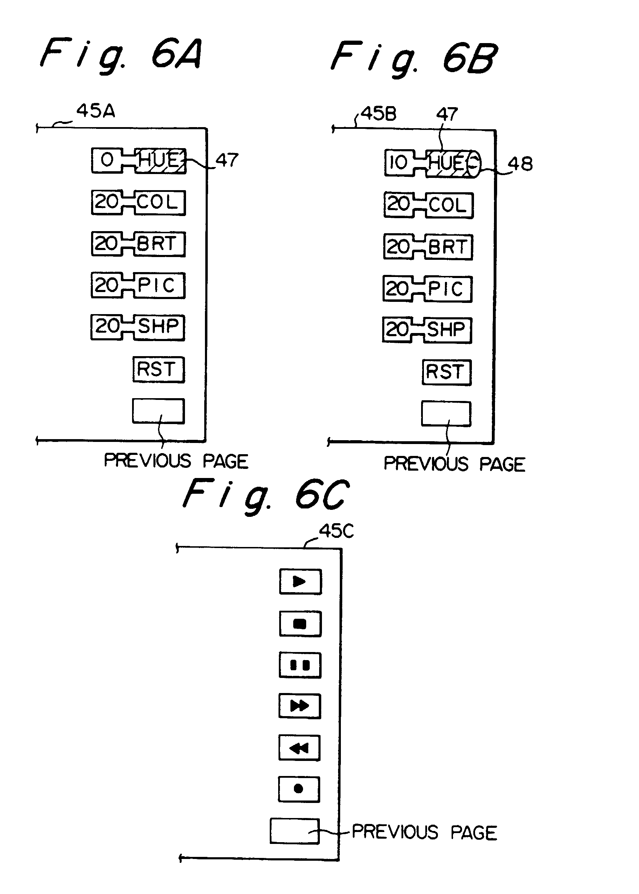

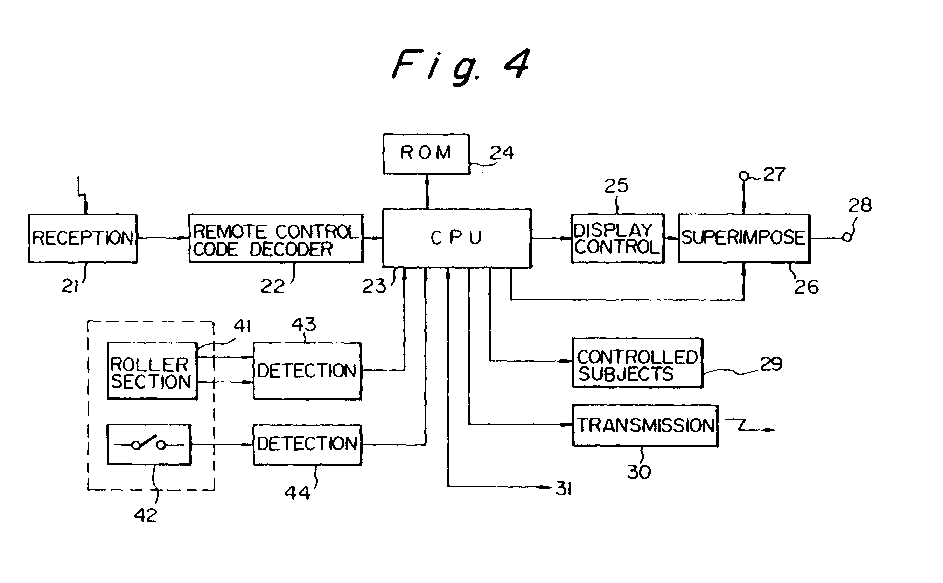

When the roller 1a is rotated by the finger of the operator, the cursor on the screen is moved. After one of the adjustment subjects is selected and then the roller 1a is pressed, a display screen 45A shown in Fig. 6A is displayed on the display 45. The display screen 45A displays controlled subjects and their controlling amounts which are vertically disposed as display blocks. In the example of the figure, there are display blocks with respect to hue control (range of controlling amount: -31 to +32), color control (range of controlling amount 0 to 63), brightness control (range of controlling amount: 0 to 63), picture (brightness level) control (range of controlling amount: 0 to 63), and sharpness control (range of controlling amount: -31 to +32). In addition, a reset display block for restoring each controlling amount to the initial value and a previous page display block are disposed on the screen.

As an example, when the hue control is performed, a cursor 47, for example, red cursor, is placed at the position of the hue control display block. The background color of other display blocks is white. When the roller 1a is pressed and thereby the switch 2 is turned on, the hue control function can be selected. At that time, as shown in Fig. 6B, on the display of the television receiver, the cursor 47 blinks and a mark 48 representing that the function mode of the roller 1a is changed from the pointing device function into the controlling amount input function appears. With the blinking of the cursor 47 and the appearance of the mark 48, the operator can easily know that the function mode of the roller 1a is changed.

It is also possible to display the change of the function mode of the roller 1a by means of a shape, color, mark, or the like other than that shown in the figure.

When the operator upwardly rotates the roller 1a while watching a display screen 458 shown in Fig. 45B, a control signal is supplied to a control terminal of a hue control circuit in the internally controlled subjects 29 so that the controlling amount is increased and the numeric value on the display screen 458 is proportionally increased. In contrast, when the operator downwardly rotates the roller 1a while watching the display screen 45B shown in Fig. 45B, the control signal is supplied to the control terminal of the hue control circuit in the internally controlled subjects 29 so that the control amount is decreased and the numeric value on the display screen 458 is proportionally decreased. Likewise, other adjustments other than the hue control can be performed only with the operation of the roller 1a.

When the operator selects the previous page display block by rotating the roller 1a and presses it, a display screen 45C for controlling the VTR as shown in Fig. 6C can be displayed on the display. On the display screen 45C, display blocks with respect to the VTR operations such as playback, record, and fast forward are disposed vertically. When the operator rotates the roller 1a, selects the desired display block, and presses the roller 1a, a remote control signal in accordance with the selected operation is transmitted from the transmission circuit 30 to the VTR. In addition, the VTR transmits a return signal representing the operation state thereof to the television receiver as an infrared ray signal. With the return signal, the operation state of the external VTR can be displayed on the display screen 45C.

In the case where the return signal is not transmitted, only while the transmission circuit 30 is transmitting the remote control signal, the color of the cursor is changed orthe cursor is blinked. Afterthe transmission of the remote control signal is completed, the normal screen is displayed.

In the aforementioned embodiment, the case where the cursor is moved upwardly and downwardly was described. However, it is possible to move the cursor leftwardly and rightwardly in accordance with the rotation of the roller. In this case, the controlled subjects will be disposed horizontally on the screen. It is also possible to move the cursor in an oblique direction.

In addition, in the case where the CRT display is not used, when the commander is provided with the display section as shown in Fig. 2C, the same control operations as those of the aforementioned embodiment can be accomplished.

According to the present invention, with the operations of a single roller, signals in accordance with the rotating direction, the amount of rotation, and the depression of the roller can be generated. Thus, the operability is high. In addition, the single roller can work both for a pointing device and a controlling amount input device. The function mode of the roller can be easily known through a display screen. Moreover, the present invention only has one moving direction of up-down, left-right, and oblique. Thus, when the cursor is moved as the pointing device, it can be readily placed at a desired position. In addition, with the present invention, the operator can operate the roller without watching his or her hand. Moreover, as opposed to the mouse, the input apparatus does not need its operating space.

In the control system according to the present invention, when the number of controlled subjects is changed or increased, the new controlled subjects can be treated only by changing the software of the unit to be controlled without modifying the structure of the commander having the roller section. Furthermore, it is not necessary to change the operation method of the commander.

Having described a specific preferred embodiment of the present invention with reference to the accompanying drawings, it is to be understood that the invention is not limited to that precise embodiment, and that various changes and modifications may be effected therein by one skilled in the art without departing from the scope of the invention as defined in the appended claims.

## Claims

1. A remote control system having a television receiver (45) which can be controlled by infrared remote control signals, comprising:
remote transmitter means for transmitting remote control signals including a user-rotatable roller (2a),
rotation detecting means (1) provided to detect the rotating direction and the amount of rotation of said roller (2a),
first detection circuit (3) for generating first control signals signifying the rotating direction and the amount of rotation in dependence on the signals from the rotation detecting means (1),
a switch (2) being responsive to the activation of said roller (2a) by pushing
second detecting means (4) for generating second control signals in response to said switch activation, and
means (5,6) for encoding and transmitting remote command signals to said television receiver (45) in accordance with said first or second control signals, characterized in that said roller (2a) is supported by a flexible axis (11), said flexible axis being a rod shaped spring (11).

2. A remote control system having a television receiver (45) which can be controlled by infrared remote control signals, comprising:
remote transmitter means for transmitting remote control signals including
a user-rotatable roller (2a)
rotation detecting means (1) provided to detect the rotating direction and the amount of rotation of said roller,
first detection circuit (3) for generating first control signals signifying the rotating direction and the amount of rotation in dependence on the signals from said rotation detecting means (1),
a switch (2) being responsive to the activation of said roller (2a) by pushing,
second detecting means (4) for generating second control signals in response to said switch activation, and
means (5,6) for encoding and transmitting remote command signals to said television receiver in accordance with said first or second control signals;
display means for displaying a plurality of categories to be selected or control amount of the selected category on the screen of said television receiver (45);
selecting means for selecting one categroy from said categories or for changing the control amount by the signals in accordance with said first control signals of said first detecting means (1); and
performing means for performing one selected control in accordance with said second control signals,
characterized in that said roller (2a) is supported by a flexible axis (11), said flexible axis being a rod shaped spring (11).

3. A remote control system as set forth in claim 2, wherein said display means displays different screens depending on whether said roller (2a) Is used for selecting one of said categories or for inputting the control amount.

## Patentansprüche

1. Fernsteuersystem mit einem Fernsehempfänger (45), der durch Infrarotfernsteuersignale gesteuert werden kann, umfassend:
eine Fernübertragungseinrichtung zur Übertragung von Fernsteuersignalen mit
einer drehbaren Benutzerrolle (2a),
einer Drehbewegungsermittlungseinrichtung (1), die dazu vorgesehen ist, die Drehrichtung und den Drehbetrag der Rolle (2a) zu ermitteln,
einer ersten Ermittlungsschaltung (3) zum Erzeugen von ersten Steuersignalen, die die Drehbewegungsrichtung und den Drehbetrag in Abhängigkeit von Signalen von der Drehbewegungsermittlungseinrichtung (1) anzeigen,
einem Schalter (2), der auf die Aktivierung der Rolle (2a) durch Drücken reagiert,
einer zweiten Ermittlungseinrichtung (4) zur Erzeugung von zweiten Steuersignalen in Abhängigkeit von der Aktivierung des Schalters, und
einer Einrichtung (5, 6) zur Codierung und Übertragung von Fernbefehlssignalen zu dem Fernsehempfänger (45) gemäß den ersten oder zweiten Steuersignalen,
**dadurch gekennzeichnet**,
daß die Rolle (2a) durch eine flexible Achse (11) gelagert ist, wobei die flexible Achse durch eine Stabfeder (11) gebildet ist.

2. Fernsteuersystem mit einem Fernsehempfänger (45), der durch Infrarotfernsteuersignale gesteuert werden kann, umfassend:
eine Fernübertragungseinrichtung zur Übertragung von Fernsteuersignalen mit
einer drehbaren Benutzerrolle (2a),
einer Drehbewegungsermittlungseinrichtung (1), die dazu vorgesehen ist, die Drehrichtung und den Drehbetrag der Rolle (2a) zu ermitteln,
einer ersten Ermittlungsschaltung (3) zum Erzeugen von ersten Steuersignalen, die die Drehbewegungsrichtung und den Drehbetrag in Abhängigkeit von Signalen von der Drehbewegungsermittlungseinrichtung (1) anzeigen,
einem Schalter (2), der auf die Aktivierung der Rolle (2a) durch Drücken reagiert,
einer zweiten Ermittlungseinrichtung (4) zur Erzeugung von zweiten Steuersignalen in Abhängigkeit von der Aktivierung des Schalters, und einer Einrichtung (5, 6) zur Codierung und Übertragung von Fernbefehlssignalen zu dem Fernsehempfänger (45) gemäß den ersten oder zweiten Steuersignalen,
eine Anzeigeeinrichtung zur Anzeige von mehreren Kategorien, die ausgewählt werden sollen, oder des Steuerungsbetrags der ausgewählten Kategorien auf dem Bildschirm des Fernsehempfängers (45),
eine Auswahleinrichtung zur Auswahl einer Kategorie aus diesen Kategorien oder zur Änderung des Steuerungsbetrages durch die Signale gemäß den ersten Steuersignalen der ersten Ermittlungseinrichtung (1), und
eine Durchführungseinrichtung zur Durchführung einer ausgewählten Steuerung gemäß den zweiten Steuersignalen,
**dadurch gekennzeichnet**,
daß die Rolle (2a) durch eine flexible Achse (11) gelagert ist, wobei die flexible Achse durch eine Stabfeder (11) gebildet ist.

3. Fernsteuersystem nach Anspruch 2, wobei die Anzeigeeinrichtung unterschiedliche Masken in Abhängigkeit davon anzeigt, ob die Rolle (2a) zur Auswahl der Kategorien oder zur Eingabe des Steuerungsbetrags verwendet wird.

## Revendications

1. Système de télécommande ayant un récepteur de télévision (45) qui peut être commandé par des signaux infrarouges de télécommande, comprenant :
un moyen de transmission de télécommande pour transmettre des signaux de télécommande comprenant
un rouleau que l'utilisateur peut faire tourner (2a),
un moyen de détection de rotation (1) prévu pour détecter la direction de rotation et la quantité de rotation dudit rouleau (2a),
un premier circuit de détection (3) pour générer des premiers signaux de commande signifiant la direction de rotation et la quantité de rotation en fonction des signaux du moyen de détection de rotation (1),
un commutateur (2) étant sensible à l'activation dudit rouleau (2a) par pression
un second moyen de détection (4) pour générer lesdits seconds signaux de commande en réponse à ladite activation de commutateur, et
un moyen (5,6) pour coder et transmettre des signaux de télécommande audit récepteur de télévision (45) selon lesdits premiers ou seconds signaux de commande, caractérisé en ce que ledit rouleau (2a) est supporté par un axe souple (11), ledit axe souple étant un ressort en forme de tige (11).

2. Système de télécommande ayant un récepteur de télévision (45) qui peut être commandé par des signaux infrarouges de télécommande, comprenant :
un moyen d'émetteur pour transmettre des signaux de télécommande comprenant :
un rouleau que l'utilisateur peut faire tourner (2a)
un moyen de détection de rotation (1) prévu pour détecter la direction de rotation et la quantité de rotation dudit rouleau,
un premier circuit de détection (3) pour générer des premiers signaux de commande signifiant la direction de rotation à la quantité de rotation en fonction des signaux dudit moyen de détection de rotation (1),
un commutateur (2) étant sensible à l'activation dudit rouleau (2a) par pression,
un second moyen de détection (4) pour générer des seconds signaux de commande en réponse à ladite activation de commutateur, et
un moyen (5,6) pour coder et transmettre des signaux de télécommande audit récepteur de télévision selon lesdits premiers ou seconds signaux de commande ;
un moyen d'affichage pour afficher une pluralité de catégories à sélectionner ou une quantité commandée de la catégorie sélectionnée sur l'écran dudit récepteur de télévision (45) ;
un moyen de sélection pour sélectionner une catégorie à partir desdites catégories et pour changer la quantité commandée par les signaux selon lesdits premiers signaux de commande dudit premier moyen de détection (1) ;
et
un moyen de réalisation pour réaliser une commande sélectionnée selon lesdits seconds signaux de commande,
caractérisé en ce que ledit rouleau (2a) est supporté par un axe souple (11), ledit axe souple étant un ressort en forme de tige (11).

3. Système de télécommande selon la revendication 2, dans lequel ledit dispositif d'affichage affiche différents écrans en fonction de si ledit rouleau (2a) est utilisé pour sélectionner une desdites catégories ou pour introduire la quantité commandée.
